# FASCICULE DE BREVET EUROPEEN

(11) **EP 1 395 991 B1**
(45) Date de publication et mention de la délivrance du brevet: **11.08.2010**
(21) Numéro de dépôt: 01945459.4
(22) Date de dépôt: 15.06.2001
(51) Int. Cl.: G11C 5/06, G11C 7/00

(54) **CIRCUIT INTEGRE A FAIBLE CONSOMMATION ELECTRIQUE, AYANT UNE INTERFACE DE COMMUNICATION "UN FIL"**
INTEGRIERTE SCHALTUNG MIT NIEDRIGER LEISTUNG UND MIT EINDRAHT KOMMUNIKATIONSINTERFACE
INTEGRATED CIRCUIT WITH REDUCED POWER CONSUMPTION HAVING A ONE WIRE COMMUNICATION INTERFACE

(43) Date de publication de la demande: 10.03.2004
(73) Titulaire: STMicroelectronics S.A., 92120 Montrouge (FR)
(72) Inventeur: GIOVINAZZI, Thierry, F-13100 Aix en Provence (FR); GANIVET, Filipe, F-13770 Venelles (FR)
(74) Mandataire: Marchand, André
(86) Numéro de dépôt international: PCT/FR2001/001879
(87) Numéro de publication internationale: WO 2002/103701

(56) Documents cités:
- WO-A-97/04376
- US-A- 4 145 760
- US-A- 4 876 535
- US-A- 5 864 872

## Description

La présente invention concerne un circuit intégré comprenant une borne de connexion pour recevoir un signal électrique porteur de données, et des moyens pour délivrer un premier signal d'horloge comprenant des impulsions d'horloge émises après chaque front descendant du signal électrique porteur de données, à l'intérieur d'une fenêtre d'échantillonnage de données.

Un circuit intégré du type mentionné ci-dessus est décrit dans le brevet US 5,210,846. Un tel circuit intégré présente une interface de communication "un fil" ("one wire") contrôlée par un protocole d'émission-réception de données permettant de véhiculer des données sur un seul fil en mode semi-duplex, tout en assurant la transmission d'un signal d'horloge. WO 97/04376, sur lequel le préambule est basé, décrit une interface de communication "un fil" ("one wire") et des moyens pour délivrer un signal d'horloge.

La présente invention concerne plus particulièrement la gestion de la consommation électrique d'un tel circuit intégré.

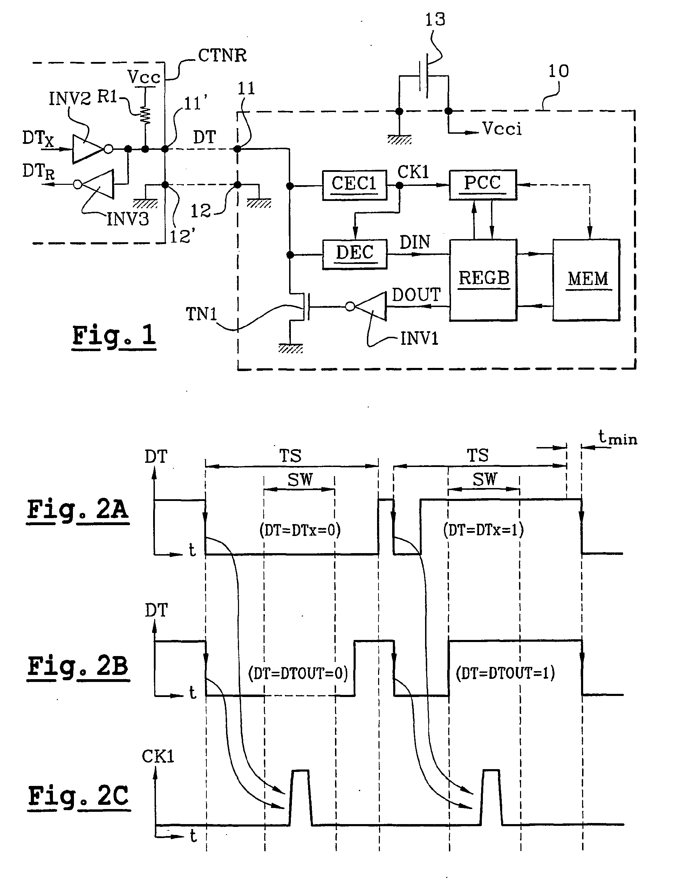

Un exemple de circuit intégré 10 ayant une interface de communication "un fil" est représenté en figure 1. Le circuit intégré 10 comprend une borne de communication 11, une borne de masse 12, un circuit d'extraction d'horloge CEC1 délivrant un signal d'horloge CK1 et un circuit d'extraction de données DEC délivrant des données DT_{IN}, les circuits CEC1 et DEC étant tous deux connectés en entrée à la borne 11. Le circuit intégré 10 comprend également un circuit de contrôle de protocole PCC, des registres à entrée série et sortie parallèle ou entrée parallèle et sortie série, représenté schématiquement sous la forme d'une banque de registres REGB, et une mémoire MEM. La mémoire MEM est de type FLASH, EEPROM, ROM ou RAM ou comprend un mélange de ces divers types de mémoire. Le signal d'horloge CK1 délivré par le circuit CEC1 est appliqué au circuit DEC et au circuit de contrôle de protocole PCC. Outre l'exécution du protocole de communication, le circuit PCC assure également le contrôle des registres de la banque REGB et le contrôle de la mémoire MEM en lecture et en écriture.

Les données DIN délivrées par le circuit DEC sont stockées dans des registres de la banque REGB avant d'être traitées. Il s'agit par exemple de commandes (codes opération), d'adresses de données à enregistrer ou à lire dans la mémoire MEM, ou de données à enregistrer dans la mémoire.

Le circuit intégré 10 comprend également des moyens d'émission de données DT_{OUT}, comprenant essentiellement un interrupteur connecté entre la borne 11 et la masse, par exemple un transistor MOS TN1, et une porte inverseuse INV1 dont la sortie pilote la borne de commande (grille) du transistor interrupteur TN1. L'entrée de la porte INV1 est reliée à la sortie série d'un registre de la banque de registres REGB. Les données susceptibles d'être émises sont par exemple des données lues dans la mémoire MEM ou des messages du circuit PCC à l'attention du contrôleur.

Un contrôleur CNTR, destiné à échanger des données avec le circuit intégré 10, est également représenté en figure 1. La borne 11 du circuit intégré 10 est connectée à une borne correspondante 11' du contrôleur CNTR, et la borne de masse 12 est connectée à une borne correspondante 12' du contrôleur.

L'échange de données bidirectionnelle en mode semi-duplex entre le circuit intégré 10 et le contrôleur CNTR est basé sur un contrôle partagé de la valeur du signal DT présent sur l'interface de communication "un fil", soit ici la borne 11 du circuit intégré 10 et la borne 11' du contrôleur CNTR. Le contrôleur comprend une résistance de polarisation à l'état haut R1 (résistance "pull-up") qui impose sur l'interface de communication une tension Vcc représentant la valeur logique 1. L'émission de données DT_{X} par le contrôleur est assurée par l'intermédiaire d'une porte inverseuse INV2 à drain ouvert (qui n'impose que le niveau bas) recevant en entrée les données DT_{X}. La réception de données DT_{R} par le contrôleur est assurée par une porte inverseuse INV3 connectée en entrée à la borne 11'. L'envoi de données DT_{OUT} par le circuit intégré 10 est assuré par l'interrupteur TN1, dont la résistance série à l'état passant RDS_{ON} est très inférieure à la résistance R1.

Les figures 2A, 2B représentent l'allure du signal DT respectivement lors de la réception de données et lors de l'envoi de données par le circuit intégré 10. La figure 2C représente l'allure du signal d'horloge CK1 délivré par le circuit CEC1. Que l'on soit en mode réception ou émission de données, le signal DT présente toujours des intervalles temporels TS ("time slot") délimités par des fronts descendants du signal DT, lesquels sont imposés par le contrôleur. Dans chaque intervalle temporel est prévue une fenêtre d'échantillonnage SW pour la réception ou l'émission d'une donnée. En mode réception de données (fig. 2A, DT=DT_{X}) la valeur du signal DT dans la fenêtre SW est imposée par le contrôleur, au moyen de la porte inverseuse INV2 (bit à 0) et de la résistance R1 (bit à 1). En mode émission de données (fig. 2B, DT=DT_{OUT}) la valeur du signal DT dans la fenêtre SW est imposée par le circuit intégré (traits pointillés) grâce au transistor interrupteur TN1, qui peut être dans l'état passant (bit à 0) ou bloqué (bit à 1). Le signal d'horloge CK1 délivré par le circuit extracteur d'horloge CEC1 présente une impulsion d'horloge après chaque front descendant du signal DT, l'impulsion d'horloge étant émise à l'intérieur de la fenêtre d'échantillonnage SW.

Un tel circuit intégré présente l'avantage de ne nécessiter que deux contacts électriques, un pour le signal DT et l'autre pour la masse, et trouve diverses applications dans le domaine des jetons électroniques, une face d'un jeton servant par exemple de borne de communication 11 et l'autre de borne de masse 12, tel que cela est décrit dans le brevet US 5,210,846 précité.

Un inconvénient de ce genre d'application réside dans la nécessité d'alimenter électriquement le circuit intégré. On doit ainsi prévoir, dans un jeton, un emplacement permettant d'agencer en sus du circuit intégré une pile électrique 13, par exemple une pile bouton, délivrant une tension Vcci d'alimentation du circuit intégré.

La présente invention repose sur l'idée selon laquelle la tension Vcc véhiculée par le signal DT pourrait être utilisée pour alimenter électriquement le circuit intégré 10, en redressant le signal DT au moyen d'une diode et en stabilisant la tension redressée au moyen d'un condensateur de forte valeur. Toutefois, il apparaît qu'un tel condensateur, dont la taille doit demeurer raisonnable au regard des contraintes d'encombrement à respecter, ne permet pas de stocker une quantité électrique suffisante pour assurer le fonctionnement du circuit intégré 10 lorsque le signal DT est à 0 et lorsque des opérations de traitement de données sont effectuées, par exemple la lecture ou l'écriture de données dans la mémoire MEM ou dans un registre de la banque de registres REGB. Pour comprendre ce problème, considérons à titre d'exemple le cas où le contrôleur envoie une suite de 0 au circuit intégré. Le signal DT est à 0 pendant toute la période de transmission des 0 sauf pendant les brefs instants où il est mis à 1 par le contrôleur afin de faire apparaître les fronts descendants nécessaires à la génération du signal d'horloge CK1 et à la séparation des intervalles temporels TS. Dans une telle situation, l'énergie électrique moyenne pouvant être extraite du signal DT est faible et un condensateur même de forte valeur s'avère insuffisant pour assurer l'alimentation électrique du circuit intégré.

La présente invention vise à pallier cet inconvénient.

Plus particulièrement, un objectif de la présente invention est de prévoir un procédé de gestion de la consommation électrique d'un circuit intégré du type décrit ci-dessus permettant d'alimenter tout ou partie du circuit intégré par la tension présente sur son interface de communication "un fil".

Un autre objectif de la présente invention est de prévoir, dans un circuit intégré du type décrit ci-dessus, des moyens de gestion de la consommation électrique permettant d'alimenter un tel circuit intégré en tout ou en partie à partir de son interface de communication.

Pour atteindre ces objectifs, l'idée de la présente invention est de prévoir un second signal d'horloge ne comprenant que des impulsions d'horloge émises quand le signal DT est au niveau haut, et de synchroniser au second signal d'horloge la réalisation d'opérations consommatrices d'énergie. On s'assure ainsi que la tension Vcc est présente sur l'interface de communication lorsque ces opérations sont réalisées.

Plus particulièrement, la présente invention prévoit un circuit intégré du type décrit ci-dessus selon la revendication 1.

Selon un mode de réalisation, le circuit intégré comprend des moyens d'émission-réception de données cadencés par le premier signal d'horloge.

Selon un mode de réalisation, les moyens de traitement de données comprennent une mémoire et des moyens de lecture et d'écriture de la mémoire.

Selon un mode de réalisation, les moyens pour délivrer un second signal d'horloge sont agencés pour délivrer une impulsion du second signal d'horloge après chaque front descendant du signal électrique porteur de données.

Selon un mode de réalisation, les moyens pour délivrer un second signal d'horloge sont agencés pour délivrer une impulsion du second signal d'horloge après chaque émission d'une impulsion du premier signal d'horloge.

Selon un mode de réalisation, les moyens pour délivrer un second signal d'horloge comprennent un circuit à logique câblée recevant en entrée le premier signal d'horloge et le signal électrique porteur de données.

Selon un mode de réalisation, les moyens pour délivrer un second signal d'horloge comprennent une bascule recevant sur une première entrée le premier signal d'horloge et sur une seconde entrée un signal délivré par un circuit à retard recevant en entrée le second signal d'horloge, la sortie de la bascule étant appliquée sur une entrée du circuit logique.

Selon un mode de réalisation, le circuit intégré comprend une borne pour recevoir un signal d'horloge externe et des moyens pour injecter le signal d'horloge externe sur une ligne conductrice prévue pour véhiculer le premier signal d'horloge.

Selon un mode de réalisation, le circuit intégré comprend des moyens pour extraire du signal électrique porteur de données une tension assurant l'alimentation électrique de tout ou partie du circuit intégré.

Selon un mode de réalisation, le circuit intégré est alimenté exclusivement par la tension extraite du signal porteur de données.

La présente invention concerne également un procédé de gestion de la consommation électrique d'un circuit intégré du type décrit ci-dessus selon la revendication 11.

Selon un mode de réalisation, une impulsion du second signal d'horloge est émise après chaque front descendant du signal électrique porteur de données.

Selon un mode de réalisation, une impulsion du second signal d'horloge est émise après chaque émission d'une impulsion du premier signal d'horloge.

Selon un mode de réalisation, des éléments du circuit intégré assurant l'émission ou la réception de données sont cadencés par le premier signal d'horloge.

Selon un mode de réalisation, le procédé est appliqué à un circuit intégré comprenant une mémoire et des moyens de lecture et écriture de la mémoire, et les moyens de lecture et écriture de la mémoire sont cadencés par le second signal d'horloge.

Selon un mode de réalisation, une impulsion du second signal d'horloge est générée par combinaison logique du premier signal d'horloge et du signal électrique porteur de données, et une impulsion du second signal d'horloge est remise à zéro après un intervalle de temps déterminé par un circuit à retard.

Selon un mode de réalisation, le circuit intégré est alimenté exclusivement par la tension extraite du signal porteur de données.

Ces objets, caractéristiques et avantages ainsi que d'autres de la présente invention seront exposés plus en détail dans la description suivante du procédé selon l'invention et d'un exemple de réalisation d'un circuit intégré selon l'invention, faite à titre non limitatif en relation avec les figures jointes parmi lesquelles :
- la figure 1 précédemment décrite est le schéma-bloc d'un circuit intégré classique ayant une interface de communication "un fil",
- les figures 2A, 2B, 2C précédemment décrites sont des chronogrammes illustrant l'émission et la réception de données sur une interface de communication "un fil", et la génération d'un signal d'horloge à partir du signal présent sur l'interface de communication,
- les figures 3A, 3B, 3C illustrent le procédé selon l'invention et représentent respectivement un signal porteur de données présent sur une interface de communication "un fil", un premier signal d'horloge classique extrait du signal porteur de données, et un second signal d'horloge selon l'invention extrait du signal porteur de données,
- la figure 4 est le schéma-bloc d'un circuit intégré selon l'invention ayant une interface de communication "un fil",
- la figure 5 est le schéma logique d'un circuit d'extraction d'un second signal d'horloge selon l'invention,
- les figures 6A à 6G sont des chronogrammes illustrant le fonctionnement du circuit représenté en figure 5, et
- les figure 7 représente une caractéristique optionnelle d'un circuit intégré selon l'invention.

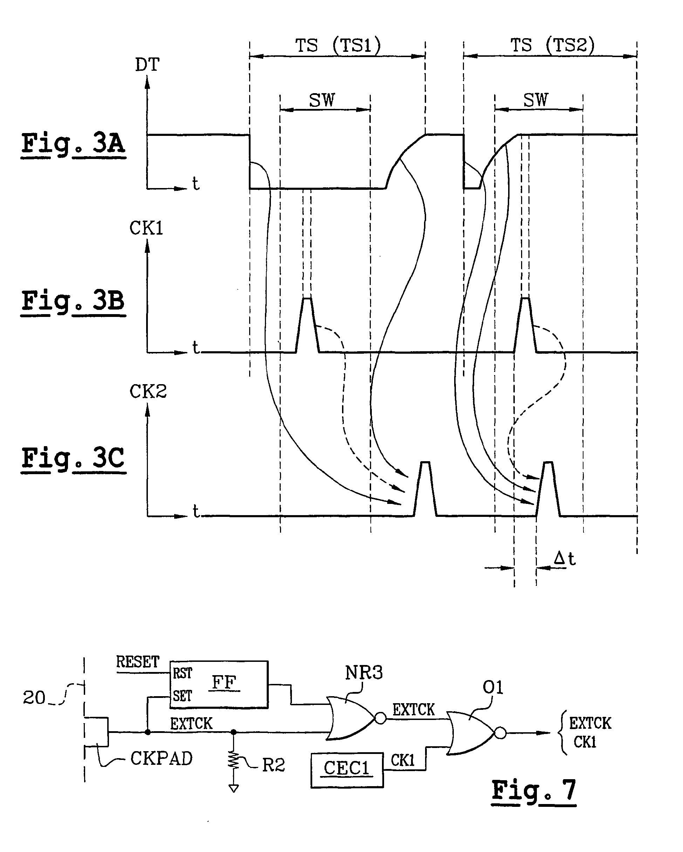

La figure 3A représente le signal DT porteur de données présent sur une interface de communication "un fil", déjà décrit au préambule en relation avec les figures 2A et 2B. Ce signal présente toujours un front descendant au commencement de chaque intervalle temporel TS et présente, même en cas de transmission d'un 0 dans la fenêtre d'échantillonnage SW, au moins une période à 1 de courte durée nécessaire à la génération du front descendant marquant le commencement de l'intervalle temporel suivant. Ce front descendant est également nécessaire à la génération du signal d'horloge CK1, représenté en figure 3B (équivalente à la figure 2B), dont les impulsions se trouvent dans la fenêtre d'échantillonnage SW.

L'idée de base de l'invention, illustrée par la figure 3C, consiste à prévoir un second signal d'horloge CK2 dont les impulsions sont émises uniquement lorsque le signal porteur de données DT est au niveau haut, de préférence après chaque front descendant du signal DT. Le signal d'horloge classique CK1 est utilisé pour synchroniser l'envoi et la réception de données, tandis que le second signal d'horloge CK2 est utilisé pour synchroniser des opérations de traitement de données qui sont consommatrices d'énergie électrique et ne nécessitent pas d'être effectuées à l'intérieur de la fenêtre d'échantillonnage SW. Ainsi, selon l'invention, une impulsion du signal d'horloge CK2 est émise lorsque le signal DT, après avoir présenté un front descendant, est revenu à 1. Dans le premier intervalle temporel TS1 représenté sur les figures 3A à 3C, une impulsion d'horloge CK2 est émise en dehors de la fenêtre d'échantillonnage SW car le signal DT est à 0 dans la fenêtre d'échantillonnage SW (émission ou réception d'un 0) et ne passe à 1 que peu de temps avant le front descendant marquant le commencement de l'intervalle temporel suivant TS2. Par contre, dans le second intervalle temporel TS2, l'impulsion d'horloge CK2 se trouve dans la fenêtre d'échantillonnage SW car la valeur du signal DT est à 1 dans la fenêtre d'échantillonnage.

En pratique, le signal CK2 peut être généré à partir d'un circuit à logique câblée recevant en entrée le signal DT. Il faut alors détecter chaque front descendant du signal DT puis attendre le front montant suivant. Selon un aspect de l'invention, il est plus simple de générer le signal CK2 au moyen d'un circuit à logique câblée recevant en entrée le signal CK1 et le signal DT, l'apparition d'une impulsion du signal CK1 servant de moyen de détection d'un front descendant du signal DT. Dans ce cas, on observe dans l'intervalle temporel TS2 un certain décalage Δt entre l'impulsion d'horloge CK1 et l'impulsion d'horloge CK2, qui est imposé par le circuit à logique câblée, dont un exemple de réalisation sera décrit plus loin.

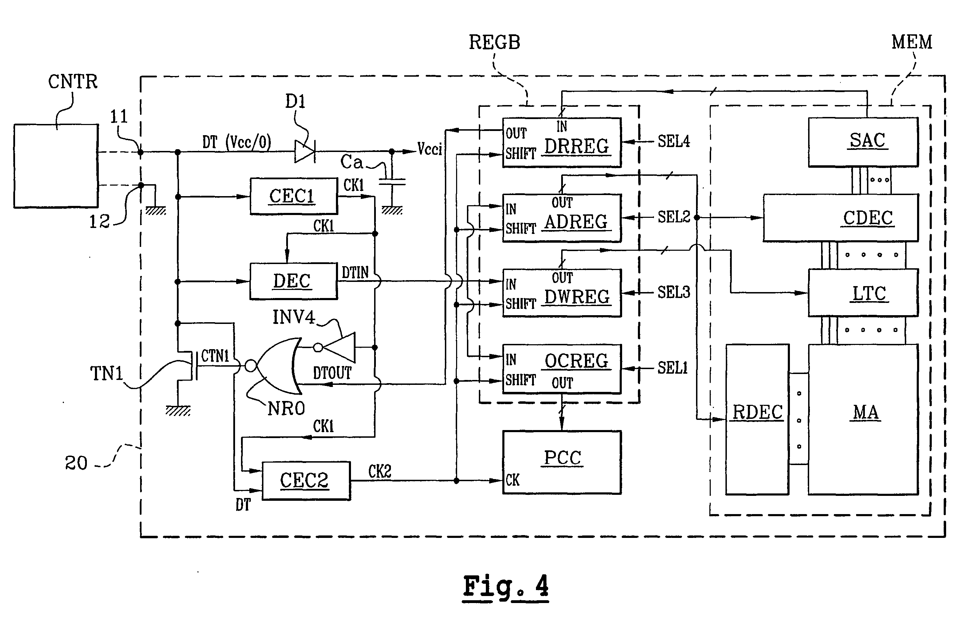

Le procédé selon l'invention est mis en oeuvre ici dans le cadre de la réalisation d'un circuit intégré 20 alimenté exclusivement par le signal DT, représenté en figure 4. L'architecture générale du circuit intégré 20 est très proche de celle du circuit 10 décrit au préambule, les mêmes éléments étant désignés par les mêmes références. Le circuit intégré 20 comprend ainsi une borne de communication 11 et une borne de masse 12 connectées ou destinées à être connectées à un contrôleur CNTR, un circuit extracteur d'horloge CEC1 recevant en entrée le signal DT et délivrant le signal d'horloge CK1, un circuit extracteur de données DEC recevant en entrée le signal DT et délivrant des données DT_{IN}, un circuit de contrôle de protocole PCC, une banque de registres REGB, une mémoire MEM, et un transistor TN1 connecté à la borne 11 pour l'émission de données DT_{OUT}. Un exemple de réalisation des circuits CEC1 et DEC est représenté en figure 8A du brevet US 5,210,846. La mémoire MEM, ici du type EEPROM, comprend un plan mémoire MA, un décodeur de ligne RDEC, un décodeur de colonne CDEC, une rangée LTC de verrous de programmation et un circuit de lecture SAC comprenant des amplificateurs de lecture ("sense amplifiers").

Selon l'invention, le circuit intégré 20 comprend un circuit extracteur d'horloge CEC2 délivrant le second signal d'horloge CK2 décrit plus haut. Le circuit CEC2 reçoit en entrée la sortie du circuit CEC1, soit le signal d'horloge CK1, et le signal DT prélevé sur la borne 11. Le signal CK2 est appliqué au circuit PCC et à la banque de registres REGB pour le cadencement des opérations de lecture et d'écriture de la mémoire MEM, ainsi que les opérations de lecture et de chargement des registres de la banque de registres REGB. Le signal d'horloge CK1 est appliqué de façon classique au circuit d'extraction de données DEC et est également utilisé pour cadencer des opérations d'émission de données. A cet effet, des données à émettre DT_{OUT} sont appliquées sur la grille du transistor TN1 par l'intermédiaire d'une porte NR0 à deux entrées de type NON OU. La porte NR0 reçoit sur sa première entrée les données DT_{OUT} et sur sa deuxième entrée le signal CK1 inversé, le signal CK1 étant appliqué sur la deuxième entrée par l'intermédiaire d'une porte inverseuse INV4. La porte NR0 délivre un signal CTN1 de commande de la grille du transistor TN1 dont la valeur est donnée par la table suivante :

| DT_{OUT} | CK1 | CTN1 |
|---|---|---|
| 0 | 0 | 0 (forcé à 0 par CK1) |
| 0 | 1 | 1 (/DT_{OUT}) |
| 1 | 0 | 0 (forcé à 0 par CK1) |
| 1 | 1 | 0 (/DT_{OUT}) |

Ces divers éléments sont alimentés électriquement par une tension Vcc1 délivrée par la cathode d'une diode de redressement D1 recevant sur son anode le signal DT. La cathode de la diode D1 est connectée à un condensateur de lissage Ca de forte valeur. Le condensateur Ca est de préférence un condensateur intégré réalisé par exemple par un sandwich polysilicium-oxyde-silicum, mais peut également être un condensateur externe connecté à des bornes d'alimentation du circuit intégré 20 (non représentées).

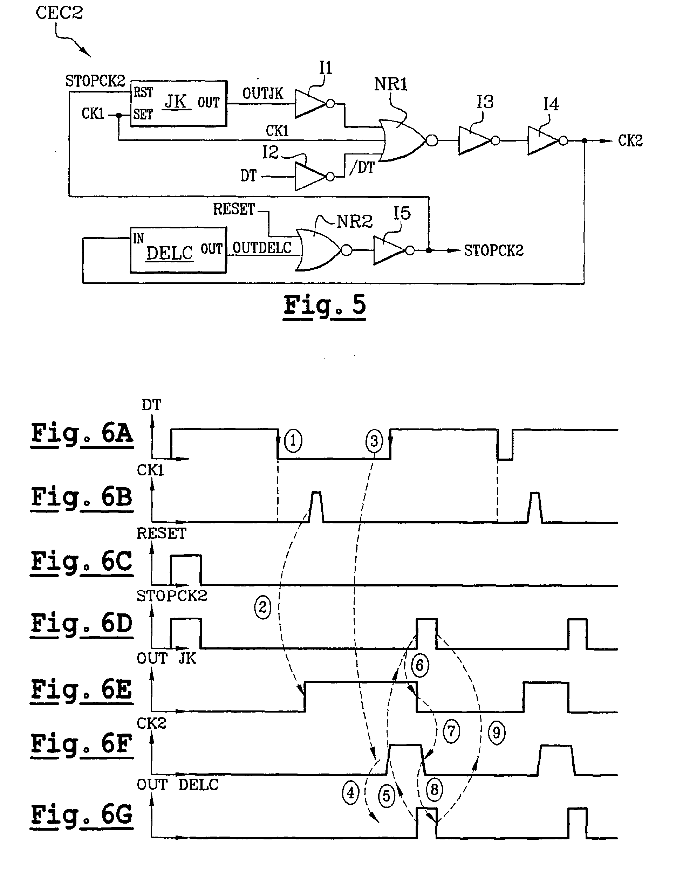

La figure 5 représente un exemple de réalisation du circuit CEC2. Le circuit CEC2 comprend une bascule JK recevant sur son entrée SET (entrée de mise à 1) le signal CK1 et recevant sur son entrée RST (entrée de mise à 0) un signal STOPCK2. La sortie de la bascule JK délivre un signal OUTJK appliqué en entrée d'une porte inverseuse Il dont la sortie est connectée sur une entrée d'une porte NR1 de type NON OU. La porte NR1 reçoit sur une deuxième entrée le signal CK1 et sur une troisième entrée un signal /DT délivré par une porte inverseuse I2 recevant le signal DT en entrée. La sortie de la porte NR1 est connectée à deux portes inverseuses en cascade I3, I4, la porte I4 délivrant le signal CK2.

Le circuit CEC2 comprend également un circuit à retard DELC recevant en entrée le signal CK2 et délivrant un signal OUTDELC. Un signal de remise à zéro externe RESET et le signal OUTDELC sont appliqués sur les entrées d'une porte NR2 de type NON OU dont la sortie est appliquée à une porte inverseuse I5. La sortie de la porte I5 délivre le signal STOPCK2 et est connectée à l'entrée RST de la bascule JK.

Les figures 6A à 6G illustrent le fonctionnement du circuit et représentent respectivement le signal DT, le signal CK1, le signal RESET, le signal STOPCK2, le signal OUTJK, le signal CK2 et le signal OUTDELC. On distingue une étape d'initialisation du circuit CEC2 consistant à mettre temporairement à 1 le signal RESET pour forcer à 1 le signal STOPCK2, ce qui provoque la mise à 0 de la bascule JK. On distingue ensuite les étapes suivantes, lorsque le signal DT présente un front descendant suivi d'un front montant :
1) l'apparition d'un front descendant du signal DT provoque l'émission d'une impulsion du signal d'horloge CK1,
2) le front montant du signal CK1 fait passer à 1 le signal OUTJK,
3) après un délai déterminé (qui dépend de la valeur du bit émis dans la fenêtre d'échantillonnage) le signal DT repasse à 1, ce qui fait passer à 1 le signal CK2 (début de l'impulsion d'horloge CK2),
4) après un délai déterminé, le circuit DELC fait passer à 1 le signal OUTDELC,
5) le passage à 1 du signal OUTDELC fait passer à 1 le signal STOPCK2,
6) le passage à 1 du signal STOPCK2 fait passer à 0 le signal OUTJK,
7) le passage à 0 du signal OUTJK fait passer à 0 le signal CK2 (fin de l'impulsion d'horloge CK2),
8) le passage à 0 du signal CK2 remet à 0 le signal OUTDELC, et
9) le passage à 0 du signal OUTDELC remet à 0 le signal STOPCK2.

On notera que l'échelle de temps est sensiblement dilatée sur ces figures après le passage à 1 du signal DT, dans un souci de lisibilité des figures et de représentation des étapes 3 à 9.

En référence à la figure 4, le fonctionnement du circuit 20 en mode écriture de la mémoire sera maintenant décrit à l'aide d'un exemple, en considérant qu'un octet B1 doit être écrit dans la mémoire MEM. Le circuit intégré 20 reçoit ainsi du contrôleur CNTR la suite de trois octets suivants : [CODE_{WRITE}] [ADD1] [B1], comprenant le code opération CODE_{WRITE} de l'instruction, une adresse ADD1 d'écriture de l'octet B1, et l'octet B1 lui-même. Un octet CRC de détection d'erreur peut également être prévu mais ne sera pas décrit ici dans un souci de simplicité.

Lors de la réception du code opération CODE_{WRITE}, les bits de code sont délivrés par le circuit DEC en synchronisation avec le signal d'horloge CK1, et sont enregistrés dans un registre OCREG à entrée série, en synchronisation avec le signal d'horloge CK2. A cet effet, le circuit PCC applique au registre OCREG un signal de sélection SEL1 et les impulsions du signal d'horloge CK2 sont utilisées comme signal de décalage SHIFT du registre OCREG. D'autres modes de réalisation sont bien entendu envisageables. Par exemple, le signal SHIFT pourrait être délivré par le circuit PCC en synchronisation avec le signal d'horloge CK2. Chaque bit de code est ainsi enregistré dans le registre OCREG lorsque le signal DT est à 1, c'est-à-dire lorsque la tension Vcc est présente sur l'anode de la diode D1, de sorte que le condensateur Ca n'est que faiblement sollicité.

Lors de la réception des bits d'adresse ADD1, l'adresse est enregistrée dans un registre ADREG de la même manière, c'est-à-dire au moyen du signal CK2 utilisé en tant que signal de décalage, après sélection du registre ADREG par le circuit PCC au moyen d'un signal VAL2.

Lors de la réception des bits de l'octet B1, un registre DWREG est sélectionné par le circuit PCC au moyen d'un signal VAL3 et le signal CK2 est également utilisé comme signal de décalage du registre DWREG.

Une fois que l'adresse ADD1 et l'octet B1 sont chargés dans les registres ADREG et DWREG, le circuit PCC procède à l'enregistrement du mot dans la mémoire MEM, toujours en synchronisation avec le signal d'horloge CK2. Les décodeurs REDC et CDEC de la mémoire sont connectés à une sortie parallèle du registre ADREG est reçoivent respectivement les bits de poids fort et les bits de poids faible de l'adresse ADD1. La rangée de verrous est connectée à une sortie parallèle du registre DWREG et huit verrous sélectionnés par le décodeur de colonne CDEC reçoivent simultanément les huit bits du mot B1. Lorsque le mot B1 est chargé dans les verrous, le circuit PCC lance une opération d'écriture du plan mémoire MA sur réception d'une impulsion du signal CK2. Ainsi, toutes les opérations de traitement de données, y compris d'écriture du plan mémoire (effacement/programmation), sont effectuées lorsque le signal Vcc est présent sur l'anode de la diode D1.

Le fonctionnement du circuit 20 en mode lecture de la mémoire sera maintenant décrit en supposant qu'un octet B2 doit être lu dans la mémoire à une adresse ADD2. La banque de registres comprend à cet effet un registre de sortie DRREG à entrée parallèle et sortie série, dont l'entrée parallèle est connectée au circuit de lecture SAC du plan mémoire et dont la sortie série délivre des données DT_{OUT} et est connectée à l'entrée la porte NR0. Le circuit intégré 20 reçoit du contrôleur CNTR les deux octets suivants : [CODE_{READ}] [ADD2], comprenant le code de l'opération à effectuer et l'adresse ADD2. Ces deux octets sont chargés dans les registres OCREG et ADREG de la manière décrite plus haut, en synchronisation avec le signal d'horloge CK2. Le circuit PCC procède ensuite à une lecture de l'octet B2 présent à l'adresse ADD2, en activant le circuit de lecture SAC et en chargeant les données dans le registre DRREG. Le circuit PCC applique ensuite au registre DREG un signal de sélection VAL4 de manière que les impulsions du signal d'horloge CK2 agissent comme signal de décalage SHIFT sur ce registre. Chaque bit de l'octet B2 est délivré en synchronisation avec le signal d'horloge CK2 en tant que donnée DT_{OUT}, puis est appliqué inversé sur la grille du transistor TN1 en synchronisation avec le signal d'horloge CK1, grâce à la porte NR0.

Ainsi, les opérations de lecture du mot B1, à l'exception de l'envoi de bits du mot B1 sur l'interface de communication, sont effectuées en synchronisation avec le signal d'horloge CK2, lorsque la tension Vcc est présente sur l'anode de la diode D1.

Il apparaîtra clairement à l'homme de l'art que la présente invention est susceptible de diverses variantes et applications. Bien que la présente invention ait été prévue en relation avec le souhait d'alimenter exclusivement un circuit intégré par l'intermédiaire de l'interface de communication "un fil", il va de soi que la présente invention n'est pas limitée à cette seule application. Notamment, un circuit intégré selon l'invention pourrait être alimenté électriquement par une pile électrique en dehors des périodes d'activation de l'interface de communication, et la tension Vcci extraite de signal DT pourrait être utilisée pendant les périodes de communication pour préserver l'autonomie de la pile électrique voire pour recharger la pile. D'autre part, un circuit intégré selon l'invention peut comprendre deux modes d'alimentation électrique, l'un par l'intermédiaire de bornes d'alimentation classiques, l'autre par l'intermédiaire de l'interface de communication. Le choix du mode d'alimentation peut être laissé au soin de l'utilisateur, selon l'application visée, grâce à un micro-commutateur prévu sur le circuit intégré. Ainsi, il va de soi que la caractéristique du second signal d'horloge CK2 selon l'invention peut également se trouver sur un circuit intégré alimenté électriquement par une pile ou tout autre moyen.

D'autre part, selon un aspect optionnel de la présente invention représenté en figure 7, le circuit 20 est équipé d'une plage de contact CKPAD permettant de lui appliquer un signal d'horloge externe EXTCK, notamment pendant des périodes de test. Il s'agit ici de réduire la durée des périodes de test en appliquant au circuit intégré un signal d'horloge EXTCK ayant une fréquence plus élevée que celle qu'il est possible d'appliquer avec le protocole de communication "un fil". Le niveau électrique sur la plage CKPAD est maintenu par défaut à la valeur 0 par une résistance R2 de polarisation à l'état bas ("pull-down"). La plage CKPAD est connectée à une entrée RST de mise à 0 d'une bascule FF de type Flip-Flop recevant sur son entrée SET de mise à 1 le signal RESET. La plage CKPAD est également connectée à l'entré d'une porte NR3 de type NON OU recevant sur une deuxième entrée la sortie de la bascule FF. La sortie de la porte NR3 est connectée à l'entrée d'une porte O1 de type OU recevant sur une deuxième entrée la sortie du circuit CEC1. La sortie de la porte O1 est connectée à la ligne électrique véhiculant le signal CK1 dans le circuit intégré. Lorsque aucun signal d'horloge externe n'est appliqué sur la plage CKPAD et que le signal RESET a été appliqué au circuit intégré, la sortie de la bascule FF est à 1 et la sortie de la porte NR3 est forcée à 0. La porte O1 est transparente vis-à-vis de la sortie du circuit CEC1 et recopie le signal CK1. Lorsqu'un signal d'horloge externe EXTCK est appliqué sur la plage CKPAD, le premier front montant du signal CKPAD met à 0 la sortie de la bascule FF et la sortie de la porte NR3 délivre le signal EXTCK inversé. Grâce à la borne CKPAD, il devient possible d'effectuer des séquences de test à grande vitesse sur le circuit intégré, sans qu'il soit nécessaire d'appliquer sur l'interface de communication des séquences de bits dans lesquelles chaque envoi d'un bit est précédé d'un front descendant du signal DT.

## Revendications

1. Circuit intégré (20) comprenant :
- une borne de connexion (11) pour recevoir un signal électrique (DT) porteur de données, et
- des moyens (CEC1) pour délivrer un premier signal d'horloge (CK1) comprenant des impulsions d'horloge émises après chaque front descendant du signal électrique porteur de données, à l'intérieur d'une fenêtre (SW) d'échantillonnage de données,
**caractérisé en ce qu'**il comprend :
- des moyens (CEC2) pour délivrer un second signal d'horloge (CK2) comprenant des impulsions d'horloge émises uniquement lorsque le signal électrique (DT) porteur de données est au niveau haut, de telle sorte qu'une impulsion du second signal d'horloge est émise à l'extérieur de la fenêtre d'échantillonnage (SW) lorsque le signal électrique (DT) porteur de données est au niveau bas à l'intérieur de la fenêtre d'échantillonnage, et
- des moyens de traitement de données (PCC, REGB, MEM), cadencés par le second signal d'horloge (CK2).

2. Circuit intégré selon la revendication 1, comprenant des moyens d'émission-réception de données (DEC, NR0, TN1) cadencés par le premier signal d'horloge.

3. Circuit intégré selon l'une des revendications 1 et 2, dans lequel les moyens de traitement de données comprennent une mémoire (MEM) et des moyens (PCC, REGB) de lecture et d'écriture de la mémoire.

4. Circuit intégré selon l'une des revendications 1 à 3, dans lequel les moyens (CEC2) pour délivrer un second signal d'horloge (CK2) sont agencés pour délivrer une impulsion du second signal d'horloge après chaque front descendant du signal électrique (DT) porteur de données.

5. Circuit intégré selon la revendication 4, dans lequel les moyens pour délivrer un second signal d'horloge sont agencés pour délivrer une impulsion du second signal d'horloge après chaque émission d'une impulsion du premier signal d'horloge (CK1) .

6. Circuit intégré selon l'une des revendications 4 et 5, dans lequel les moyens (CEC2) pour délivrer un second signal d'horloge comprennent un circuit à logique câblée (NR1, I1, I2, I3, I4) recevant en entrée le premier signal d'horloge (CK1) et le signal électrique (DT) porteur de données.

7. Circuit intégré selon la revendication 6, dans lequel les moyens (CEC2) pour délivrer un second signal d'horloge comprennent une bascule (JK) recevant sur une première entrée le premier signal d'horloge (CK1) et sur une seconde entrée un signal (STOPCK2) délivré par un circuit à retard (DELC) recevant en entrée le second signal d'horloge (CK2), la sortie de la bascule étant appliquée sur une entrée (I1) du circuit logique.

8. Circuit intégré selon l'une des revendications 1 à 7, comprenant une borne (CKPAD) pour recevoir un signal d'horloge externe (EXTCK) et des moyens pour injecter le signal d'horloge externe sur une ligne conductrice prévue pour véhiculer le premier signal d'horloge (CK1).

9. Circuit intégré selon l'une des revendications 1 à 8, comprenant des moyens (D1) pour extraire du signal électrique (DT) porteur de données une tension (Vcci) assurant l'alimentation électrique de tout ou partie du circuit intégré.

10. Circuit intégré selon la revendication 9, alimenté exclusivement par la tension (Vcci) extraite du signal porteur de données.

11. Procédé de gestion de la consommation électrique d'un circuit intégré (20) comprenant une borne de connexion (11) pour recevoir un signal électrique (DT) porteur de données, et des moyens (CEC1) pour délivrer un premier signal d'horloge (CK1) comprenant des impulsions d'horloge émises après chaque front descendant du signal électrique (DT) porteur de données, à l'intérieur d'une fenêtre (SW) d'échantillonnage de données,
**caractérisé en ce qu'**il comprend les étapes consistant à :
- extraire (D1) une tension (Vcci) du signal électrique (DT) porteur de données,
- alimenter des éléments (CEC1, DEC, PCC, REGB, MEM) du circuit intégré au moyen de la tension extraite du signal électrique porteur de données,
- délivrer un second signal d'horloge (CK2) comprenant des impulsions d'horloge émises uniquement lorsque le signal électrique porteur de données est au niveau haut, de telle sorte qu'une impulsion du second signal d'horloge est émise à l'extérieur de la fenêtre d'échantillonnage (SW) lorsque le signal électrique (DT) porteur de données est au niveau bas à l'intérieur de la fenêtre d'échantillonnage, et
- cadencer au moyen du second signal d'horloge (CK2) des éléments (PCC, REGB, MEM) du circuit intégré alimentés par la tension extraite du signal électrique porteur de données.

12. Procédé selon la revendication 11, dans lequel une impulsion du second signal d'horloge (CK2) est émise après chaque front descendant du signal électrique (DT) porteur de données.

13. Procédé selon la revendication 12, dans lequel une impulsion du second signal d'horloge (CK2) est émise après chaque émission d'une impulsion du premier signal d'horloge (CK1).

14. Procédé selon l'une des revendications 11 à 13, dans lequel des éléments du circuit intégré assurant l'émission ou la réception de données sont cadencés par le premier signal d'horloge (CK1).

15. Procédé selon la revendication 14, appliqué à un circuit intégré comprenant une mémoire (MEM) et des moyens (PCC, REGB) de lecture et écriture de la mémoire, dans lequel les moyens (PCC, REGB) de lecture et écriture de la mémoire sont cadencés par le second signal d'horloge (CK2).

16. Procédé selon l'une des revendications 11 à 15, dans lequel :
- une impulsion du second signal d'horloge (CK2) est générée par combinaison logique (NR1, I2) du premier signal d'horloge (CK1) et du signal électrique (DT) porteur de données, et
- une impulsion du second signal d'horloge (CK2) est remise à zéro (STOPCK2) après un intervalle de temps déterminé par un circuit à retard (DEC).

17. Procédé selon l'une des revendications 11 à 16, dans lequel le circuit intégré est alimenté exclusivement par la tension (Vcci) extraite du signal (DT) porteur de données.

## Claims

1. An integrated circuit (20) comprising:
- a connection terminal (11) for receiving a data-carrier electric signal (DT), and
- means (CEC1) for delivering a first clock signal (CK1) comprising clock pulses emitted after each falling edge of the data-carrier electric signal, inside a data sampling window (SW),
**characterized in that** it comprises:
- means (CEC2) for delivering a second clock signal (CK2) comprising clock pulses emitted only when the data-carrier electric signal (DT) is at the high level, such that a pulse of the second clock signal is emitted outside the sampling window (SW) when the (DT) data-carrier electric signal is at the low level inside the sampling window, and
- data processing means (PCC, REGB, MEM), paced by the second clock signal (CK2).

2. Integrated circuit according to claim 1, comprising data send/receive means (DEC, NR0, TN1) paced by the first clock signal.

3. Integrated circuit according to one of claims 1 and 2, wherein the data processing means comprise a memory (MEM) and means (PCC, REGB) for reading and writing the memory.

4. Integrated circuit according to one of claims 1 to 3, wherein the means (CEC2) for delivering a second clock signal (CK2) are arranged for delivering a pulse of the second clock signal after each falling edge of the data-carrier electric signal (DT).

5. Integrated circuit according to claim 4, wherein the means for delivering a second clock signal are arranged for delivering a pulse of the second clock signal after each emission of a pulse of the first clock signal (CK1).

6. Integrated circuit according to one of claims 4 and 5, wherein the means (CEC2) for delivering a second clock signal comprise a hard-wired logic circuit (NR1, I1, I2, I3, I4) receiving at input the first clock signal (CK1) and the data-carrier electric signal (DT).

7. Integrated circuit according to claim 6, wherein the means (CEC2) for delivering a second clock signal comprise a flip-flop (JK) receiving at a first input the first clock signal (CK1) and at a second input a signal (STOPCK2) delivered by a delay circuit (DELC) receiving at input the second clock signal (CK2), the output of the flip-flop being applied to an input (I1) of the logic circuit.

8. Integrated circuit according to one of claims 1 to 7, comprising a terminal (CKPAD) for receiving an external clock signal (EXTCK) and means for injecting the external clock signal onto a conductive line provided for conveying the first clock signal (CK1).

9. Integrated circuit according to one of claims 1 to 8, comprising means (D1) for extracting from the data-carrier electric signal (DT) a voltage (Vcci) that powers all or part of the integrated circuit.

10. Integrated circuit according to claim 9, supplied exclusively by the voltage (Vcci) extracted from the data-carrier signal.

11. A method for managing the current consumption of an integrated circuit (20) comprising a connection terminal (11) for receiving a data-carrier electric signal (DT), and means (CEC1) for delivering a first clock signal (CK1) comprising clock pulses emitted after each falling edge of the data-carrier electric signal (DT), inside a data sampling window (SW),
**characterized in that** it comprises the steps of:
- extracting (D1) a voltage (Vcci) from the data-carrier electric signal (DT),
- supplying elements (CEC1, DEC, PCC, REGB, MEM) of the integrated circuit by means of the voltage extracted from the data-carrier electric signal,
- delivering a second clock signal (CK2) comprising clock pulses emitted only when the data-carrier electric signal is at the high level, such that a pulse of the second clock signal is emitted outside the sampling window (SW) when the data-carrier electric signal (DT) is at the low level inside the sampling window, and
- pacing, by means of the second clock signal (CK2), elements (PCC, REGB, MEM) of the integrated circuit supplied by the voltage extracted from the data-carrier electric signal.

12. Method according to claim 11, wherein a pulse of the second clock signal (CK2) is emitted after each falling edge of the data-carrier electric signal (DT).

13. Method according to claim 12, wherein a pulse of the second clock signal (CK2) is emitted after each emission of a pulse of the first clock signal (CK1).

14. Method according to one of claims 11 to 13, wherein elements of the integrated circuit which send or receive data are paced by the first clock signal (CK1).

15. Method according to claim 14, applied to an integrated circuit comprising a memory (MEM) and means (PCC, REGB) for reading and writing the memory, wherein the means (PCC, REGB) for reading and writing the memory are paced by the second clock signal (CK2).

16. Method according to one of claims 11 to 15, wherein:
- a pulse of the second clock signal (CK2) is generated by logic combination (NR1, I2) of the first clock signal (CK1) and of the data-carrier electric signal (DT), and
- a pulse of the second clock signal (CK2) is reset (STOPCK2) after a time interval determined by a delay circuit (DELC).

17. Method according to one of claims 11 to 16, wherein the integrated circuit is supplied exclusively by the voltage (Vcci) extracted from the data-carrier signal (DT).

## Patentansprüche

1. Integrierter Schaltkreis (20) umfassend :
- eine Anschlussklemme (11) zum Empfang eines elektrischen Datenträgersignals (DT) und
- Mittel (CEC1) zur Abgabe eines ersten Taktsignals (CK1) umfassend Taktimpulse, die nach jeder fallenden Flanke des elektrischen Datenträgersignals innerhalb eines Daten-Sampling-Fensters (SW) abgegeben werden, **dadurch gekennzeichnet, dass** er folgendes umfasst:
- Mittel (CEC2) zur Abgabe eines zweiten Taktsignals (CK2) umfassend Taktimpulse, die nur dann abgegeben werden, wenn das elektrische Datenträgersignal (DT) auf hohen Pegel ist, so dass ein Impuls des zweiten Taktsignals ausserhalb des Sampling-Fensters (SW) abgegeben wird, wenn das elektrische Datenträgersignal (DT) auf niedrigen Pegel innerhalb des Sampling-Fensters ist, und
- vom zweiten Taktsignal (CK2) getaktete Datenverarbeitungsmittel (PCC, REGB, MEM).

2. Integrierter Schaltkreis nach Anspruch 1, umfassend vom ersten Taktsignal getaktete Datensende - und -empfangsmittel (DEC, NR0, TN1).

3. Integrierter Schaltkreis nach einem der Ansprüche 1 und 2, in dem die Datenverarbeitungsmittel einen Speicher (MEM) und Mittel (PCC, REGB) zum Lesen und Schreiben des Speichers umfassen.

4. Integrierter Schaltkreis nach einem der Ansprüche 1 bis 3, in dem die Mittel (CEC2) zur Abgabe eines zweiten Taktsignals (CK2) ausgelegt sind, um einen Impuls des zweiten Taktsignals nach jeder fallenden Flanke des elektrischen Datenträgersignals (DT) abzugeben.

5. Integrierter Schaltkreis nach Anspruch 4, in dem die Mittel zur Abgabe eines zweiten Taktsignals ausgelegt sind, um einen Impuls des zweiten Taktsignals nach jedem Senden eines Impulses des ersten Taktsignals (CK1) abzugeben.

6. Integrierter Schaltkreis nach einem der Ansprüche 4 und 5, in dem die Mittel (CEC2) zur Abgabe eines zweiten Taktsignals eine Schaltung mit verdrahteter Logik (NR1, I1, I2, I3, I4) umfassen, die am Eingang das erste Taktsignal (CK1) und das elektrische Datenträgersignal (DT) empfängt.

7. Integrierter Schaltkreis nach Anspruch 6, in dem die Mittel (CEC2) zur Abgabe eines zweiten Taktsignals ein Flip-Flop (JK) umfassen, das auf einem ersten Eingang das erste Taktsignal (CK1) und auf einem zweiten Eingang ein Signal (STOPCK2) empfängt, das von einer Verzögerungsschaltung (DELC) abgegeben wird, die am Eingang das zweite Taktsignal (CK2) empfängt, wobei der Ausgang des Flip-Flop an einen Eingang (I1) der Logikschaltung angelegt wird.

8. Integrierter Schaltkreis nach einem der Ansprüche 1 bis 7, umfassend eine Klemme (CKPAD) zum Empfang eines externen Taktsignals (EXTCK) und Mittel um das externe Taktsignal in eine leitfähige Leitung zu injizieren, die dafür vorgesehen ist, das erste Taktsignal (CK1) zu transportieren.

9. Integrierter Schaltkreis nach einem der Ansprüche 1 bis 8, umfassend Mittel (D1) um aus dem elektrischen Datenträgersignal (DT) eine Spannung (Vcci) zu extrahieren, die die elektrische Versorgung des gesamten oder eines Teils des integrierten Schaltkreises gewährleistet.

10. Integrierter Schaltkreis nach Anspruch 9, der ausschließlich mit der aus dem Datenträgersignal extrahierten Spannung (Vcci) gespeist wird.

11. Verfahren zur Verwaltung des Stromverbrauchs eines integrierten Schaltkreises (20) umfassend eine Anschlussklemme (11) zum Empfang eines elektrischen Datenträgersignals (DT) und Mittel (CEC1) zur Abgabe eines ersten Taktsignals (CK1) umfassend Taktimpulse, die nach jeder fallenden Flanke des elektrischen Datenträgersignals (DT) innerhalb eines Daten-Sampling-Fensters (SW) abgegeben werden,
**dadurch gekennzeichnet, dass** es folgende Schritte umfasst, die darin bestehen:
- eine Spannung (Vcci) aus dem elektrischen Datenträgersignal (DT) zu extrahieren (D1),
- Elemente (CEC1, DEC, PCC, REGB, MEM) des integrierten Schaltkreises mittels der aus dem elektrischen Datenträgersignal extrahierten Spannung zu speisen,
- ein zweites Taktsignal (CK2) umfassend Taktimpulse, die nur dann abgegeben werden, wenn das elektrische Datenträgersignal auf hohen Pegel ist, so dass ein Impuls des zweiten Taktsignals ausserhalb des Sampling-Fensters (SW) abgegeben wird, wenn das elektrische Datenträgersignal (DT) auf niedrigen Pegel innerhalb des Sampling-Fensters ist, und
- von der aus dem elektrischen Datenträgersignal extrahierten Spannung gespeisten Elemente (PCC, REGB, MEM) des integrierten Schaltkreises mittels des zweiten Taktsignals (CK2) zu takten.

12. Verfahren nach Anspruch 11, in dem ein Impuls des zweiten Taktsignals (CK2) nach jeder fallenden Flanke des elektrischen Datenträgersignals (DT) abgegeben wird.

13. Verfahren nach Anspruch 12, in dem ein Impuls des zweiten Taktsignals (CK2) nach jedem Senden eines Impulses des ersten Taktsignals (CK1) abgegeben wird.

14. Verfahren nach einem der Ansprüche 11 bis 13, in dem Elemente des integrierten Schaltkreises, die das Senden oder das Empfangen von Daten gewährleisten, von dem ersten Taktsignal (CK1) getaktet werden.

15. Verfahren nach Anspruch 14, angewendet auf einen integrierten Schaltkreis umfassend einen Speicher (MEM) und Mittel (PCC, REGB) zum Lesen und Schreiben des Speichers, in dem die Mittel (PCC, REGB) zum Lesen und Schreiben des Speichers von dem zweiten Taktsignal (CK2) getaktet werden.

16. Verfahren nach einem der Ansprüche 11 bis 15, in dem :
- ein Impuls des zweiten Taktsignals (CK2) durch logische Kombination (NR1, I2) des ersten Taktsignals (CK1) und des elektrischen Datenträgersignals (DT) generiert wird, und
- ein Impuls des zweiten Taktsignals (CK2) nach einem von einer Verzögerungsschaltung (DELC) festgelegten Zeitintervall auf Null zurückgestellt wird (STOPCK2).

17. Verfahren nach einem der Ansprüche 11 bis 16, in dem der integrierte Schaltkreis ausschließlich durch die aus dem Datenträgersignal (DT) extrahierte Spannung (Vcci) gespeist wird.
